# EUROPÄISCHE PATENTSCHRIFT

(11) **EP 2 264 800 B1**
(45) Veröffentlichungstag und Bekanntmachung des Hinweises auf die Patenterteilung: **07.05.2014**
(21) Anmeldenummer: 10184225.0
(22) Anmeldetag: 29.09.2004
(51) Int. Cl.: H01L 41/047, H01L 41/083, C04B 35/491

(54) **Keramisches Vielschicht-Bauelement**
Multi-layered ceramic component
Composant multicouche en céramique

(30) Priorität: 30.09.2003 DE 10345500
(43) Veröffentlichungstag der Anmeldung: 22.12.2010
(62) Teilanmeldung aus: 07017605.2
(73) Patentinhaber: EPCOS AG, 81669 München (DE)
(72) Erfinder: Florian, Heinz, 8524 Bad Gams (AT); Ottlinger, Marion, 8530 Deutschlandsberg (AT); Sedlmaier, Peter, 9113 Ruden (AT)
(74) Vertreter: Epping - Hermann - Fischer

(56) Entgegenhaltungen:
- EP-A2- 1 167 747
- WO-A1-02/06184
- WO-A2-03/073523
- DE-A1- 10 062 672
- US-A- 5 933 315
- US-A1- 2003 142 463

## Beschreibung

Die Erfindung betrifft ein keramisches Vielschicht-Bauelement mit einem Stapel alternierender Keramikschichten und kupferhaltiger, als Innenelektroden dienender Elektrodenschichten, wobei die Innenelektroden an Außenkontakte angeschlossen sind, welche an einander gegenüberliegenden Außenseiten des Stapels senkrecht zu der Schichtanordnung angeordnet sind, wobei die an verschiedenen Außenkontakten angeschlossenen Innenelektroden ineinander greifen. Ein solches Bauelement bzw. Verfahren zu dessen Herstellung ist z. B. aus der Druckschrift DE 10062672 A1 bekannt.

Aus der Druckschrift DE 9700463 ist ein Verfahren zur Herstellung von Grünfolien für piezokeramische Vielschichtbauelemente mit Ag/Pd-Innenelektroden bekannt, bei dem ein Piezokeramikpulver vom Typ PZT (PZT = Bleizirkonattitanat) eingesetzt wird.

Das Material bzw. das Verfahren zum Einbrennen der an die Innenelektroden kontaktierten Außenelektroden sollte im Prinzip so gewählt werden, daß einerseits das Elektrodenmetall nicht oxidiert und andererseits die Keramik nicht reduziert wird. Daher wird in der Regel ein Edelmetall bzw. eine Edelmetallegierung als Elektrodenmaterial verwendet.

In der Druckschrift DE 19945933 ist z. B. ein Verfahren zur Herstellung von Außenelektroden bei piezokeramischen Bauelementen auf der Basis der PZT-Keramik und der Ag/Pd-Innenelektroden beschrieben. Die Kontaktierung der Ag/Pd-Innenelektroden erfolgt mit einer Metallpaste mit einem Silbergehalt von > 65 % und einem organischen Binder, die bei ca. 700°C eingebrannt wird. Der Einbrand der Metallpaste wird in der Luftatmosphäre durchgeführt, da in dem organischen Pastenbinder enthaltene aromatische Verbindungen unter reduzierenden Bedingungen nicht vollständig zersetzt werden können. Dieses Verfahren ist jedoch für ein Vielschicht-Bauelement mit PZT-Keramik und kupferhaltigen Innenelektroden nicht geeignet, da bei den üblichen Entbinderungs- bzw. Einbrandtemperaturen nur unter einem bestimmten sehr niedrigen Sauerstoffpartialdruck von < 10⁻² Pa einerseits die PZT-Keramik nicht reduziert und andererseits metallisches Kupfer zugleich nicht oxidiert wird. Daher können die Ag/Pd-Außenelektroden in einem keramischen Vielschicht-Bauelement mit kupferhaltigen Innenelektroden nicht verwendet werden.

Mit dem aus der Druckschrift DE 1006 2672 A1 bekannten Bauelement gelingt es, den Nachteil der Kostenbelastung bei piezokeramischen Vielschichtbauelementen auf der Basis einer PZT-Keramik und Ag/Pd-Innenelektroden zu vermeiden, indem anstelle der teuren Ag/Pd-Innenelektroden kupferhaltige Innenelektroden verwendet werden. In dieser Druckschrift ist jedoch nicht erwähnt, welches Material zum Einbrennen von Außenelektroden in einem piezokeramischen Bauelement mit kupferhaltigen Innenelektroden geeignet ist.

WO 03/073523 A2 offenbart ein elektrisches Vielschicht-Bauelement, an dessen Seitenfläche eine Außenelektrode mit wenigstens einer Vertiefung aufgebracht ist. Die Außenelektrode enthält Kupfer und ist glasfrittenartig.

Die Aufgabe der Erfindung ist es, ein keramisches Vielschicht-Bauelement mit Innenelektroden und Außenkontakten zur Kontaktierung der Innenelektroden anzugeben, in dem die Haftfestigkeit der Außenkontakte ausreichend hoch ist.

Die Aufgabe der Erfindung wird durch ein keramisches Vielschicht-Bauelement gemäß Anspruch 1 gelöst. Bevorzugte Ausführungsformen werden in den abhängigen Patentansprüchen dargestellt.

Die Erfindung gibt ein keramisches Vielschicht-Bauelement mit einem Stapel alternierender Keramikschichten und als Innenelektroden dienender kupferhaltiger Elektrodenschichten, wobei die Innenelektroden an Außenkontakte angeschlossen sind. Die Außenkontakte sind an einander gegenüberliegenden Außenseiten des Stapels senkrecht zu der Schichtanordnung angeordnet, wobei die zu verschiedenen Außenkontakten angeschlossenen Innenelektroden ineinander greifen. Das Vielschicht-Bauelement ist dadurch gekennzeichnet, daß die Außenkontakte metallisches Kupfer und einen Glasfrittenanteil enthalten, wobei die Innenelektroden einen Keramikanteil aufweisen und wobei der Glaszusatz nur in den Bereich der Innenelektroden eingedrungen ist.

Die Keramikschichten weisen eine ferroelektrische Perowskitkeramik vom PZT-Typ Pb(ZrₓTi_{1-X})O₃ auf und werden vorzugsweise aus keramischen Grünfolien hergestellt, die einen thermohydrolytisch abbaubaren Binder enthalten.

Zur Herstellung eines erfindungsgemäßen Bauelements kann ein Verfahren angewendet werden, bei dem die Entbinderung bei einer Temperatur ≤ 300°C durchgeführt bzw. komplett abgeschlossen wird. Die Entbinderung erfolgt im Stickstoffstrom unter Zudosierung von Wasserdampf, wobei der Wasserdampfpartialdruck so eingestellt wird, daß der ihm entsprechende Sauerstoffpartialdruck bei der gegebenen Temperatur zwischen den Gleichgewichtspunkten von Cu/Cu₂O und PbTiO₃/Pb liegt. Der Gleichgewichtspunkt entspricht einem solchen Sauerstoffpartialdruck, bei dem sowohl ein reduziertes Metall als auch eine diesem Metall entsprechende Metallverbindung thermodynamisch stabil sind und koexisitieren können, ohne ineinander zu übergehen.

Hierbei wird der Pastenbinder in einer reduzierten Atmosphäre von z. B. < 10⁻² Pa bei einer vergleichsweise niedrigen Temperatur ≤ 300°C vollständig gespaltet, da bei höheren Entbinderungstemperaturen der für die Verbrennung des im organischen Binder enthaltenen Kohlenstoffs unzureichende Sauerstoff zum Teil aus der Gitterstruktur der Keramik herausgezogen wird, was die Eigenschaften der Keramikschichten beeinträchtigt.

Eine vollständige Spaltung organischer Anteile wird dabei dadurch ermöglicht, daß die Entbinderung im Stickstoffstrom unter Zudosierung von Wasserdampf durchgeführt wird, wobei eine hydrolytische Spaltung zustande kommt. Der Zusatz des Wasserdampfs bewirkt, daß der Sauerstoffpartialdruck thermodynamisch bedingt absinkt, wobei der Sauerstoffpartialdruck einen gewissen Wert jedoch nicht unterschreitet, bei dem die Keramik reduktiv zu degradieren anfängt.

Andererseits überschreitet der Sauerstoffpartialdruck auch nicht einen bestimmten Wert, bei dem bei der gegebenen Temperatur das metallische Kupfer anfängt zu oxidieren.

Der Sauerstoffpartialdruck wird also so niedrig gewählt, daß die Reduktionsprozesse in der Keramik noch hinreichend gehemmt sind und gleichzeitig das in der Metallpaste enthaltene Kupfer nicht mehr oxidiert.

Der Sauerstoffpartialdruck wird nicht nur beim Entbinderungsprozeß, sondern auch beim Einbrand der Metallpaste so gehalten bzw. zu jedem Zeitpunkt entsprechend der Temperatur derart angepaßt, daß er im p(T)-Diagramm bei jeder Prozeßtemperatur zwischen den Gleichgewichtspunkten von Cu/Cu₂O und Pb/PbO liegt.

Der Kupferanteil in der Metallpaste ist vorzugsweise > 70%. Als organischer Pastenbinder wird vorzugsweise Acrylharzbinder verwendet.

Hierdurch wird die Verwendung einer (kupferhaltigen) Metallpaste mit einem organischen Pastenbinder zur Herstellung von Außenkontakten in einem piezokeramischen Bauelement mit kupferhaltigen Innenelektroden ermöglicht.

Zur Herstellung von Außenkontakten wird vorzugsweise eine kupferhaltige Metallpaste mit Kupfergehalt von > 70 m%, z. B. 78 m%, einem Glasfluß und einem organischen Binder, z. B. Acrylharzbinder, verwendet.

Der Glasfluß (Glasfritte) besteht vorzugsweise im Wesentlichen aus PbO und SiO₂, kann jedoch auch weitere Bestandteile, z. B. Na₂O, Al₂O₃ und BaO aufweisen. Der Anteil des Glasflusses in der Metallpaste ist vorzugsweise kleiner als 5 m%. Die Zusammensetzung und der Anteil des Glasflusses werden so gewählt, daß die in der Metallpaste der Außenkontakte enthaltene Glasfritte teilweise in die Keramik eindiffundiert und dadurch die Haftfestigkeit der Außenkontakte an den Stapelseiten erhöht.

Zunächst wird in einem an sich bekannten Verfahren ein Stapel übereinander liegender Elektrodenschichten, die in einem fertigen Bauteil den Innenelektroden entsprechen, und Schichten aus einem Keramikmaterial erzeugt. Die Elektrodenschichten bestehen aus einer kupferhaltigen Metallpaste und können z. B. in einem Siebdruckverfahren auf die Schichten aus einem Keramikmaterial aufgetragen werden.

Die kupferhaltige Metallpaste wird ferner z. B. in einem Siebdruckverfahren auf einander gegenüberliegende Seiten des Stapels der übereinander liegenden Innenelektroden und Keramikschichten aufgebracht.

Die Metallpaste wird in einer feuchten Stickstoffatmosphäre in einem gasdichten Ofen bei einer Temperatur ≤ 300°C entbindert und anschließend bei einer höheren Temperatur gesintert.

Das Einbrennen der kupferhaltigen Metallpaste wird vorzugsweise zwischen 700 und 860°C durchgeführt.

Um Reduktion des in der Keramik enthaltenen Kupferoxids zu verhindern, können bei der Herstellung eines erfindungsgemäßen Bauelements Gitterunterlagen aus metallischem Kupfer verwendet werden, die gleichzeitig als Gettermaterial dienen.

Im Folgenden wird die Erfindung anhand von Ausführungsbeispielen und der dazugehörigen Figuren näher erläutert. Die Figuren zeigen anhand schematischer und nicht maßstabsgetreuer Darstellungen verschiedene Ausführungsbeispiele der Erfindung. Gleiche oder gleich wirkende Teile sind mit gleichen Bezugszeichen bezeichnet. Es zeigen
- Figur 1: den Aufbau eines erfindungsgemäßen Bauelements in perspektivischer Darstellung
- Figur 2: in halb-logarithmischer Darstellung die Abhängigkeit des unter der Zudosierung des Wasserdampfes einzustellenden Sauerstoffpartialdruckes von der Temperatur und die Gleichgewichtskurven von Cu/Cu₂O und Pb/PbTiO₃

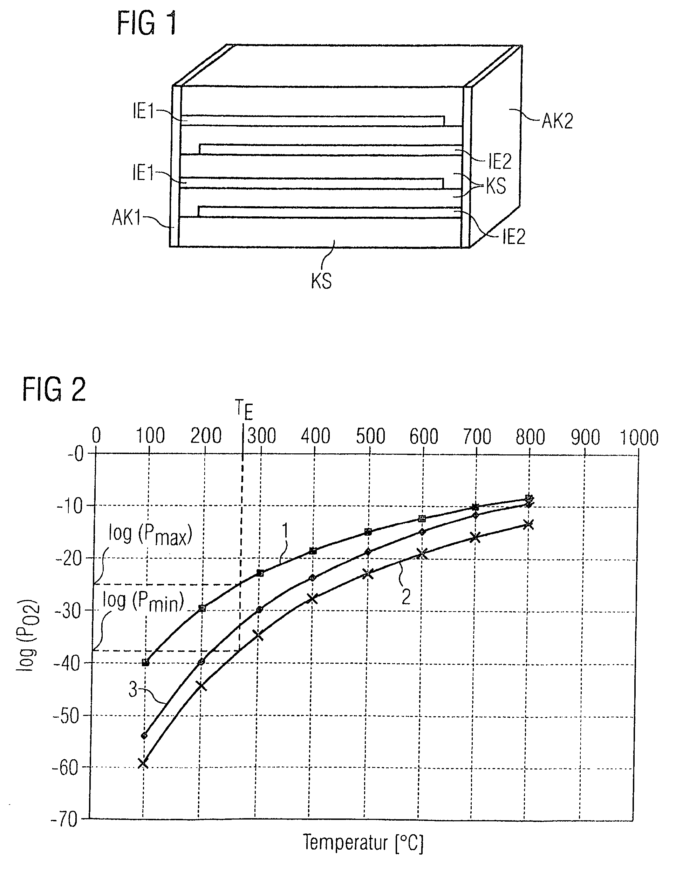

In Figur 1 ist ein keramisches Bauelement mit erfindungsgemäß kupferhaltigen Außenkontakten AK1 und AK2 schematisch gezeigt. An den ersten Außenkontakt AK1 sind erste kupferhaltige Innenelektroden IE1 angeschlossen. An den zweiten Außenkontakt AK2 sind zweite kupferhaltige Innenelektroden IE2 angeschlossen. Die Innenelektroden sind voneinander durch Keramikschichten KS getrennt.

Die Keramikschichten KS weisen piezoelektrische Eigenschaften auf und sind auf der Basis der Keramik des PZT-Typs hergestellt.

Das dargestellte Bauelement realisiert insbesondere einen Piezoaktor. Die übereinander gestapelten Elektrodenschichten und Keramikschichten werden als Piezostack bezeichnet.

Die eingebrannten Außenkontakte AK1, AK2 sind vorzugsweise zwischen 10 und 20 µm, z. B. 15 µm dick. Es kann aber auch eine andere Dicke der Außenkontakte gewählt werden.

Die Außenkontakte und Innenelektroden weisen einen bestimmten Keramik-Anteil, der vorzugsweise kleiner als 50 m% (m% = Masseprozent) ist, in einer bevorzugten Variante der Erfindung zwischen 10 und 50 m% liegt und insbesondere 40 m% beträgt, auf. Der Keramik-Anteil weist dabei Keramikpartikel mit einer bestimmten Korngröße, z. B. mit einer mittleren Korngröße zwischen 0,2 und 0,6 µm auf.

Der Keramik-Anteil in der Metallpaste verhindert insbesondere Rißbildung und Abhebung des Außenkontakts vom Piezostack, welche sich aufgrund unterschiedlicher Ausdehnungseigenschaften des Keramikmaterials und des metallischen Kupfers ergeben.

Der thermische Ausdehnungskoeffizient der Keramik des PZT-Typs beträgt im Temperaturbereich zwischen der Raumtemperatur und der Curie-Temperatur ca. 1,5 - 2,0 ppm/K, während metallisches Kupfer im entsprechenden Temperaturbereich einen wesentlich höheren thermischen Ausdehnungskoeffizienten von ca. 19 ppm/K aufweist. Durch Zumischung des Keramikmaterials in die Metallpaste wird das Ausdehnungsverhalten des Außenkontakts an das Ausdehnungsverhalten des Keramikstapels sowohl während der Prozessierung des Bauteils als auch für dessen spätere Anwendungen im spezifizierten Temperaturbereich von z. B. -50°C bis +150°C, wobei z. B. durch Anlegen eines elektrischen Feldes eine Deformation des Bauelements entsteht, angepaßt.

Zur Anpassung der thermischen Ausdehnungskoeffizienten wird vorzugsweise eine Glasfritte mit einem hohen SiO₂-Anteil von z. B. 39 m% verwendet, da SiO₂ eine hohe Affinität zur Keramik des PZT-Typs aufweist.

Bei der Zubereitung der kupferhaltigen Metallpaste wird zunächst ein Keramikpulver mit einer mittleren Korngröße von z. B. 0,4 µm in einer Dispersion mit einem Lösungsmittel fertiggestellt. Anschließend wird die Keramikpulver-Dispersion in die kupferhaltige Metallpaste der oben schon angegebenen Zusammensetzung eingerührt und mit Hilfe eines Dreiwalzenwerkes homogenisiert. Die Viskosität der Metallpaste beträgt vorzugsweise zwischen 10 und 20 Pas. Nach dem Aufbringen der fertigen Metallpaste auf die Seitenflächen des Piezostacks wird die Paste bei ca. 80 bis 140°C in der Luftatmosphäre getrocknet. Ferner erfolgt Entbinderung und Sintern unter erfindungsgemäß eingestellten Bedingungen, wobei einerseits die Oxidation des metallischen Kupfers und andererseits die Reduktion des PbO oder PbTiO₃ verhindert werden. Dabei wird insbesondere im Hinblick auf die Auswahl der Entbinderungstemperatur und die Dauer der Entbinderung darauf geachtet, daß während des Entbinderungsprozesses aus der Metallpaste nicht nur die Binderanteile, sondern auch die Lösungsmittelreste vollständig ausgebrannt werden.

Da die in der Metallpaste enthaltene Glasfritte zum Teil sehr stark in die Keramik eindiffundiert und dabei in den gesinterten Keramikschichten Hohlräume hinterläßt, wird die Sintertemperatur so niedrig (z. B. 765°C) gewählt, daß das Eindringen des Glaszusatzes nur im Bereich der Innenelektroden stattfindet. Mikroskopische Untersuchungen belegen, daß bei einer derart gewählten Sintertemperatur Glasanteile, vor allem Siliziumoxid, nur in einem an die Außenkontakte angrenzenden engen Bereich der Keramikschichten feststellbar sind. Die Außenkontakte haften fest und lassen sich nur unter Anwendung einer großen Kraft von über 50 N vom Piezostack ablösen. Bei der gewaltsamen Ablösung der Außenkontakte werden Teile des Keramikmaterials herausgebrochen, was für eine hohe Haftfestigkeit der Außenkontakte am Piezostack spricht.

Der Keramik-Anteil beträgt vorzugsweise 40 m% bezogen auf den Feststoffgehalt der Metallpaste. Diese Metallpaste kann im Prinzip auch für innen liegende Elektrodenschichten verwendet werden.

Im Rahmen der Erfindung liegt es auch, in der Elektrodenmetallisierung ein vorzugsweise chemisch aktives Keramikpulver (oder auch einen anderen chemisch aktiven Zusatzstoff), im Folgenden auch Keramikzusatz genannt, vorzusehen, das unter bestimmten Bedingungen chemisch mit dem Elektrodenmetall, dem organischen Binder, der Keramik und/oder einem Reaktionsprodukt dieser reagieren bzw. bestimmte Komponenten chemisch binden kann. Ferner kann der Keramikzusatz mit der Prozeßatmosphäre reagieren, z. B. den Sauerstoff an die Prozeßatmosphäre abgeben oder umgekehrt aufnehmen, wodurch zumindest lokal bzw. vorübergehend der Sauerstoffpartialdruck stabilisiert wird. Mit einem stabilen Sauerstoffpartialdruck gelingt es insbesondere, die innen liegenden Elektrodenschichten bzw. die Außenkontakte vor Oxidation und die Keramikschichten vor Reduktion zu schützen. Der Keramikpulver-Zusatz sorgt dafür, daß ein durch Prozeßinstabilitäten in der Elektrodenmetallisierung entstandenes Metalloxid gebunden wird, wodurch ein unerwünschtes Eindiffundieren dieses Metalloxids in die Keramikschichten vermieden wird.

Die Verwendung eines chemisch inerten Keramikpulvers in einer Metallpaste z. B. zur Verzögerung der Sinterung des Metalls ist an sich bekannt. Erfindungsgemäß wird das Keramikpulver jedoch als funktionelles Additiv verwendet, das chemisch aktiv ist und mit seiner Umgebung chemisch reagieren kann. Die chemische Aktivität kann z. B. auf die Bindung von Pb, das bei der Sinterung aus der bleihaltigen Keramikmasse freigesetzt wird, gerichtet sein. Möglich ist es auch, daß das chemisch aktive Keramikpulver eine andere Komponente der Keramikmasse insbesondere bei der Sinterung bindet oder zur Freisetzung von bestimmten Komponenten wie z. B. Sauerstoff aus der Keramikmasse oder aus dem in der Keramikmasse oder in der Metallpaste enthaltenen Binder dient. Voraussetzung ist jedoch, daß das Keramikpulver mit dem Metallanteil der Metallpaste nicht chemisch reagiert.

Im Gegensatz zu der Metallpaste, die bei den Außenelektroden verwendet wird, werden in der für die Innenelektroden-Schichten geeigneten Metallpaste vorzugsweise keine Glaszusätze verwendet. Als chemisch aktives Keramikpulver ist insbesondere (Zr,Ti)O₂ geeignet. Die Metallpaste kann anstelle eines chemisch aktiven Keramikpulver auch einen anderen chemisch aktiven Zusatzstoff oder zusätzlich zu dem chemisch aktiven Keramikpulver Anteile von weiteren Stoffen enthalten, z. B. BaO₂ und/oder MgO.

Der Zusatz eines Keramikpulvers bei den Innenelektroden sorgt außerdem für eine bessere Haftung zwischen der Innenelektrode und den diese umgebenden Keramikschichten, wobei durch eine feine Verteilung der Keramikpartikel zwischen den Metallpartikeln insbesondere die Sinterhalsbildung verhindert wird. Die Sinterhälse stellen eine lokale Unterbrechung der Innenelektrode dar, wobei sich die Metallisierung von der Keramikschicht löst und/oder - vor allem im Randbereich - zurückgezogen wird, so daß die Innenelektrode eine netzförmige Struktur annimmt, deren Struktur von Bauteil zu Bauteil nicht reproduzierbar ist. Es ist bekannt, daß eine homogene Innenelektrodenstruktur auch durch den Zusatz eines Edelmetalls oder einer Edelmetallegierung erreicht werden kann. Der erfindungsgemäße Zusatz des Keramikpulvers hat demgegenüber aber einen großen Kostenvorteil.

In der Figur 2 ist in halb-logarithmischer Darstellung ein in Abhängigkeit von der Temperatur - erfindungsgemäß unter Zudosierung des Wasserdampfes - einzustellender Sauerstoffpartialdruck p_{O2}, beispielsweise gegeben durch die Kurve 3, die numerisch berechnete Gleichgewichtskurve 1 von Cu und Cu₂O und die numerisch berechnete Gleichgewichtskurve 2 von Pb und PbTiO₃ gezeigt.

Die Gleichgewichtskurve 1 gibt bei der ausgewählten Temperatur den Partialdruck von O₂ an, bei dem metallisches Cu und Cu₂O gleichzeitig existieren können. Metallisches Kupfer existiert nur bei einem Sauerstoffpartialdruck p_{O2}, der den Gleichgewichtswert nicht übersteigt, d. h. unterhalb der Gleichgewichtskurve 1. Da oberhalb der Kurve 1 nur Cu₂O stabil ist, erfolgt bei einem Sauerstoffpartialdruck, der den Gleichgewichtswert bei der ausgewählten Temperatur übersteigt, eine unerwünschte Oxidation des metallischen Kupfers.

Die Gleichgewichtskurve 2 gibt bei der ausgewählten Temperatur den Partialdruck von O₂ an, bei dem metallisches Pb und PbTiO₃ gleichzeitig existieren können. PbTiO₃ existiert nur oberhalb der Kurve 2. Bei einem Sauerstoffpartialdruck p_{O2}, der den Gleichgewichtswert bei der ausgewählten Temperatur unterschreitet, wird das in der Keramik enthaltene PbTiO₃ zu Pb reduziert.

Daher wird zumindest in der Entbinderungsphase eines erfindungsgemäßen Verfahrens zur Herstellung eines keramischen Vielschicht-Bauelements der Sauerstoffpartialdruck p_{O2} unter Zudosierung von Wasserdampf so eingestellt, daß er einerseits den durch die Kurve 1 definierten Maximalwert pₘₐₓ, bei dem metallisches Kupfer noch stabil ist, nicht übersteigt, und anderseits den durch die Kurve 2 gegebenen Minimalwert pₘᵢₙ, bei dem Bleititanat noch nicht reduziert wird, nicht unterschreitet, d. h. pₘᵢₙ < p_{O2} < pₘₐₓ bei der gegebenen Entbinderungstemperatur T_{E}. Der zulässige Bereich zur Einstellung des Sauerstoffpartialdruckes liegt also zwischen den Kurven 1 und 2.

Die Kurve 3 beschreibt einen je nach Temperatur und in einer feuchten Atmosphäre einzustellenden, erfindungsgemäß aufgefundenen, optimalen Sauerstoffpartialdruck. Die Menge des hinzuzufügenden Wasserdampfes kann im Prinzip aus der Kurve 3 berechnet werden. Möglich ist es auch, den Abfall des Sauerstoffpartialdrucks unter Zudosierung von Wasserdampf manuell oder automatisch so zu steuern, daß die vorgegebenen Grenzwerte nicht verletzt werden.

### Bezugszeichenliste

- 1: Kennlinie des Gleichgewichts von Cu und Cu₂O im Diagramm log{p(O₂)} gegen Temperatur
- 2: Kennlinie des Gleichgewichts von Pb und PbTiO₃ im Diagramm log{p(O₂)} gegen Temperatur
- 3: Kennlinie des unter Zudosierung von Wasserdampf einzustellenden Sauerstoffpartialdrucks in Abhängigkeit von Temperatur
- AK1, AK2: Außenkontakt
- KS: Keramikschicht
- IE1: an den Außenkontakt AK1 angeschlossene Innenelektroden
- IE2: an den Außenkontakt AK2 angeschlossene Innenelektroden
- p_{O2}: Sauerstoffpartialdruck
- pₘᵢₙ: minimaler zulässiger Sauerstoffpartialdruck
- pₘₐₓ: maximaler zulässiger Sauerstoffpartialdruck
- T_{E}: Entbinderungstemperatur

## Patentansprüche

1. Keramisches Vielschicht-Bauelement mit einem Stapel alternierender Keramikschichten (KS) und als Innenelektroden dienender Elektrodenschichten,
wobei die Keramik eine Perowskit-Keramik vom PZT-Typ Pb(ZrₓTi_{1-X})O₃ mit 1 ≥ x ≥ 0 ist,
wobei die Innenelektroden (IE1, IE2) an Außenkontakte (AK1, AK2) angeschlossen sind, welche an einander gegenüberliegenden Außenseiten des Stapels senkrecht zu der Schichtanordnung angeordnet sind, wobei die an verschiedenen Außenkontakten angeschlossenen Innenelektroden ineinander greifen,
wobei die Elektrodenschichten kupferhaltig sind,
**dadurch gekennzeichnet, dass**
die Außenkontakte (AK1, AK2) metallisches Kupfer und einen Glasfritten-Anteil enthalten,
wobei die Innenelektroden einen Keramik-Anteil aufweisen, und wobei die Glasfritte nur in den Bereich der Innenelektroden eingedrungen ist.

2. Bauelement nach Anspruch 1, wobei der Glasfritten-Anteil < 5 Masseprozent ist.

3. Bauelement nach einem der Ansprüche 1 bis 2, wobei der Kupfergehalt der Außenkontakte > 70 Masseprozent ist.

4. Bauelement nach einem der Ansprüche 1 bis 3, bei dem der Keramik-Anteil ≤ 50 Masseprozent ist.

5. Bauelement nach einem der Ansprüche 1 bis 4, bei dem der Keramik-Anteil zwischen 10 und 50 Masseprozent liegt.

6. Bauelement nach einem der Ansprüche 1 bis 5, bei dem der Keramik-Anteil Keramikpartikel mit einer mittleren Korngröße zwischen 0,2 und 0,6 µm aufweist.

7. Bauelement nach einem der Ansprüche 1 bis 6, das aus keramischen Grünfolien hergestellt ist, welche einen thermohydrolytisch abbaubaren Binder enthalten.

8. Bauelement nach einem der Ansprüche 1 bis 7, bei dem die Dicke der Außenkontakte zwischen 10 bis 20 µm liegt.

9. Bauelement nach einem der Ansprüche 1 bis 8, wobei die Glasfritte PbO und SiO₂ umfasst.

## Claims

1. Multi-layered ceramic component with a stack of alternating ceramic layers (KS) and electrode layers serving as internal electrodes,
wherein the ceramic is a perovskite ceramic of the PZT type Pb(ZrₓTi_{1-X})O₃, where 1 ≥ x ≥ 0,
wherein the internal electrodes (IE1, IE2) are connected to external contacts (AK1, AK2), which are arranged on mutually opposing outer sides of the stack perpendicular to the layer arrangement, wherein the internal electrodes connected to various external contacts engage into one another, wherein the electrode layers contain copper,
**characterized in that**
the external contacts (AK1, AK2) contain metallic copper and a glass frit proportion,
wherein the internal electrodes have a ceramic proportion,
and wherein the glass frit has penetrated only into the region of the internal electrodes.

2. Component according to Claim 1, wherein the glass frit proportion is < 5% by mass.

3. Component according to either of Claims 1 and 2, wherein the copper content of the external contacts is > 70% by mass.

4. Component according to one of Claims 1 to 3, wherein the ceramic proportion is ≤ 50% by mass.

5. Component according to one of Claims 1 to 4, wherein the ceramic proportion is between 10 and 50% by mass.

6. Component according to one of Claims 1 to 5, wherein the ceramic proportion comprises ceramic particles having a mean grain size of between 0.2 and 0.6 µm.

7. Component according to one of Claims 1 to 6, which is produced from ceramic green sheets containing a thermohydrolytically degradable binder.

8. Component according to one of Claims 1 to 7, wherein the thickness of the external contacts is between 10 and 20 µm.

9. Component according to one of Claims 1 to 8, wherein the glass frit comprises PbO and SiO₂.

## Revendications

1. Composant multicouche en céramique comprenant un empilage de couches céramiques (KS) alternées et des couches d'électrodes servant d'électrodes intérieures, la céramique étant une céramique perovskite de type PZT Pb(ZrₓTi₁₋ₓ)O₃ avec 1 ≥ x ≥ 0,
les électrodes intérieures (IE1, IE2) étant connectées à des contacts extérieurs (AK1, AK2), qui sont agencés sur des côtés extérieurs opposés l'un à l'autre de l'empilage, perpendiculairement à l'agencement de couches, les électrodes intérieures connectées à différents contacts extérieurs étant imbriquées les unes dans les autres,
les couches d'électrodes contenant du cuivre,
**caractérisé en ce que**
les contacts extérieurs (AK1, AK2) contiennent du cuivre métallique et une proportion de fritte de verre,
les électrodes intérieures présentant une proportion de céramique et la fritte de verre ne pénétrant que dans la zone des électrodes intérieures.

2. Composant selon la revendication 1, dans lequel la proportion de fritte de verre est < 5 pour cent en masse.

3. Composant selon l'une quelconque des revendications 1 à 2, dans lequel la teneur en cuivre des contacts extérieurs est > 70 pour cent en masse.

4. Composant selon l'une quelconque des revendications 1 à 3, dans lequel la proportion de céramique est ≤ 50 pour cent en masse.

5. Composant selon l'une quelconque des revendications 1 à 4, dans lequel la proportion de céramique est comprise entre 10 et 50 pour cent en masse.

6. Composant selon l'une quelconque des revendications 1 à 5, dans lequel la proportion de céramique comprend des particules en céramique d'une taille de particule moyenne comprise entre 0,2 et 0,6 µm.

7. Composant selon l'une quelconque des revendications 1 à 6, qui est fabriqué à partir de feuilles en céramique non traitées, qui contiennent un liant décomposable thermohydrolytiquement.

8. Composant selon l'une quelconque des revendications 1 à 7, dans lequel l'épaisseur des contacts extérieurs est comprise entre 10 et 20 µm.

9. Composant selon l'une quelconque des revendications 1 à 8, dans lequel la fritte de verre comprend PbO et SiO₂.
